# EUROPEAN PATENT SPECIFICATION

(11) **EP 1 411 392 B1**
(45) Date of publication and mention of the grant of the patent: **17.09.2008**
(21) Application number: 03078292.4
(22) Date of filing: 17.10.2003
(51) Int. Cl.: G03F 7/20

(54) **Lithographic projection apparatus**
Lithographischer Projektionsapparat
Appareil de projection lithographique

(30) Priority: 18.10.2002 EP 02079329
(43) Date of publication of application: 21.04.2004
(73) Proprietor: ASML Netherlands B.V., 5504 DR Veldhoven (NL)
(72) Inventor: Kurt, Ralph, 5655 CG Eindhoven (NL); Bakker, Levinus Pieter, 5708 ZT Helmond (NL); Schuurmans, Frank Jeroen Pieter, 5551 XE Valkenswaard (NL)
(74) Representative: van Westenbrugge, Andries

(56) References cited:
- EP-A- 0 987 601
- EP-A- 1 182 510
- EP-A- 1 223 468

## Description

The invention relates to a lithographic projection apparatus comprising:
- a radiation system to form a projection beam of radiation, from radiation emitted by a pulsed radiation source,
- a support structure constructed to hold patterning means, to be irradiated by the projection beam to pattern said projection beam,
- a substrate table constructed to hold a substrate,
- a projection system constructed and arranged to image an irradiated portion of the patterning means onto a target portion of the substrate, and
- shield means for generating an electromagnetic field so as to prevent that released electrons, generated as a result of impinging radiation, become incident on an object to be shielded,
   said shield means comprising:

- an electrode in the vicinity of the object to be shielded, and
- a voltage source connected to the object and/or to the electrode for providing a voltage to the object relative to the electrode.

In EP 1 182 510 a lithographic projection apparatus is disclosed which uses a particle shield shaped as a mesh to protect an object such as, for instance, a mask against stray particles. The particle shield generates an electromagnetic field which will exert a force on charged particles and will deflect them from the mesh. The particle shield may be a mesh but other geometries are possible as well.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required; and
- A programmable LCD array. An example of such a construction is given in United States Patent US 5,229,872. As above, the support structure in this case may be embodied as a frame or table, for example, which may be fixed or movable as required.
   For purposes of simplicity, the rest of this text may, at certain locations, specifically directs itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus - commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

In a lithographic apparatus the size of features that can be imagined onto the substrate is limited by the wavelength of the projection radiation. To produce integrated circuits with a higher density of devices, and hence higher operating speeds, it is desirable to be able to image smaller features. Whilst most current lithographic projection apparatus employ ultraviolet light generated by mercury lamps or excimer lasers, it has been proposed to use shorter wavelength radiation in the range 5 to 20 nm, especially around 13 nm. Such radiation is termed extreme ultraviolet (EUV) or soft x-ray and possible sources include, for instance, laser-produced plasma sources, discharge plasma sources, or synchrotron radiation from electron storage rings. Apparatus using discharge plasma sources are described in: W. Partlo, I. Fomenkov, R. Oliver, D. Birx, "Development of an EUV (13.5 nm) Light Source Employing a Dense Plasma Focus in Lithium Vapor", Proc. SPIE 3997, pp. 136-156 (2000); M.W. McGeoch, "Power Scaling of a Z-pinch Extreme Ultraviolet Source", Proc. SPIE 3997, pp. 861-866 (2000); W.T. Silfvast, M. Klosner, G. Shimkaveg, H. Bender, G. Kubiak, N. Fornaciari, "High-Power Plasma Discharge Source at 13.5 and 11.4 nm for EUV lithography", Proc. SPIE 3676, pp. 272-275 (1999); and K. Bergmann et al., "Highly Repetitive, Extreme Ultraviolet Radiation Source Based on a Gas-Discharge Plasma", Applied Optics, Vol. 38, pp. 5413-5417 (1999).

EUV radiation sources may require the use of a rather high partial pressure of a gas or vapor to emit EUV radiation, such as discharge plasma radiation sources referred to above. In a discharge plasma source, for instance, a discharge is created in between electrodes, and a resulting partially ionized plasma may subsequently be caused to collapse to yield a very hot plasma that emits radiation in the EUV range. The very hot plasma is quite often created in Xe, since a Xe plasma radiates in the Extreme UV (EUV) range around 13.5 nm. For an efficient EUV production, a typical pressure of 0.1 mbar is required near the electrodes to the radiation source. A drawback of having such a rather high Xe pressure is that Xe gas absorbs EUV radiation. For example, 0.1 mbar Xe transmits over 1 m only 0.3% EUV radiation having a wavelength of 13.5 nm. It is therefore required to confine the rather high Xe pressure to a limited region around the source. To achieve this the source can be contained in its own vacuum chamber that is separated by a chamber wall from a subsequent vacuum chamber in which the collector mirror and illumination optics may be obtained.

The vacuum wall can be made transparent to EUV radiation by a number of apertures in said wall provided by a channel array or so-called "foil trap". Such a channel array or "foil trap" has been proposed in EP-A-1 223 468 and EP-A-1 057 079. This foil trap consists of a number of focused channel-like structures comprising a plurality of lamellas situated close together to form a flow resistance while allowing radiation to pass without obstructing it.

The molecular contamination by for instance carbon of the optical components in a lithographic projection apparatus (e.g. grazing incidence and multi-layer mirrors in a EUV lithographic projection apparatus) is a major problem. The contamination of the reflective elements in EUV lithographic projection apparatus is caused by the presence of hydrocarbons and released electrons that are generated by EUV illumination.

A further problem is how to monitor the dose of radiation from the source and the amount of contamination that gathers on the optical components. Molecular contamination can be reduced by repelling released electrons from the optical components. Furthermore, dose of radiation from the source and the amount of contamination that gathers on the optical components can be monitored by measuring the electron flux from the optical components. Both reduction of molecular contamination and electron flux measurements use an electric field to repel electrons from the optical components. This electric field will also accelerate positive ions towards the optical components. The resulting ion bombardment leads up to sputtering of the reflective surface.

It is therefore an object to reduce the amount of contamination caused by illumination of EUV radiation on optical components in an EUV lithographic projection apparatus.

It is another object of the invention to provide an EUV lithographic projection apparatus in which the reflective elements are shielded against released electrons and in which at the same time the attraction of positively charged particles is prevented.

It is another object of the invention to provide a technique for measuring dose and contamination.
It is another object of the invention to reduce the amount of sputtering on optical components by positive ions.

These and other objects are achieved according to the present invention in a lithographic projection apparatus as specified in the opening paragraph, characterized by the characterizing part of claim 1.Thus, the released electrons are repelled by the negative (relative) potential pulse from the surface of the object in the radiation beam, or are drawn away by the positive (relative) potential of the electrode. Besides, the amount of released electrons collected is a measure for the dose of radiation and the amount of contamination. This measure may be easily determined using current measuring means connected to the electrode. The current can also be measured at the object.

In one embodiment of a lithographic projection apparatus according to the invention, the lithographic projection apparatus is characterized in that the varying voltage imparts the negative potential to the object relative to the electrode for a time period sufficient for transporting substantially all the released electrons generated as a result of impinging radiation away from the object. In this way the released electrons are swiftly and completely removed upon generation, which is important because electrons which are present above the irradiated surface of the object enhance molecular contamination of the surface of the object. When the negative potential pulse is provided sufficiently long after the end of the EUV pulse on the object, to allow the (freed) released electrons to migrate from the object to the electrode, it is ascertained that such an electron cloud is not present.

In a further embodiment of a lithographic projection apparatus according to the invention, the lithographic projection apparatus is characterized in that the negative potential pulse is applied during a time of between 0,01 microseconds and 10 microseconds, more preferably 0,1 microsecond. This time span is long enough to properly repel the released electrons which are relatively light. It is however, short enough so as not to cause acceleration and attraction of heavier particles with a positive charge towards the objects to be shielded.

In a further embodiment of the invention therefore the lithographic projection apparatus is characterized in that the negative potential pulse is between 0 V and -1000 V, more preferably -100 V. By this voltage the released electrons can be drawn off from the object in the radiation beam or repelled therefrom such that they only cross the surface of the object once, and hence reduce the amount of contamination caused thereby.

In yet a further embodiment the invention is characterized in that the voltage source is connected to the object. Direct connection of the negative voltage to the object causes released electrons to be rapidly expelled away from the object without a chance of recapture. The positive electrode may be placed at a larger distance from the object or may be formed by the wall of the vacuum chamber.

In yet a further embodiment the invention is characterized in that the voltage source is connected to the electrode in the vicinity of the object. By applying a positive voltage to the electrode, negatively charged particles such as released electrons will be pulled away from the object.

In yet a further embodiment the invention is characterized in that the negative potential is applied in phase with the pulses of radiation. Advantageously, the released electrons that are generated during the EUV pulse are repelled from the surface on which the radiation impinges by a relatively short negative voltage pulse at the moment when they are released. Hence the possibility that they return to the surface of the object and cross the said surface for a second time, is reduced such that the chances of contamination decrease.

In yet a further embodiment the invention is characterized in that the phase difference between the application of the negative potential and pulses of radiation is arbitrary. This means that it is not very critical to drive the radiation source and provide the pulsed voltage exactly at the same time. An arbitrary phase difference between the radiation pulse and the voltage pulse is also acceptable.

In yet a further embodiment the invention is characterized in that the negative potential is succeeded by an associated positive potential. This overcomes the problem that positively charged ions will gain momentum and, particularly in a low pressure environment, move towards the surface of the object to be shielded. The reason is that the relatively heavy ions will experience the time averaged field, which in this case will approximate to zero. The relatively light released electrons, on the contrary, will conform to the momentarily present field and thus be removed by the negative voltage pulse.

The invention further relates to a method of manufacturing an integrated structure by a lithographic process as defined by claim 15.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm), as well as particle beams, such as ion beams or electron beams.

Embodiments of the invention will now be described, by way of example only, with reference to the accompanying schematic drawings in which corresponding reference symbols indicate corresponding parts, and in which:
Fig. 1 schematically depicts a lithographic projection apparatus according to an embodiment of the invention;
Fig. 2 shows a side view of an EUV illuminating system and projection optics of a lithographic projection apparatus according to the invention;
Fig. 3 shows a detail of the radiation source and grazing incidence collector of the present invention;
Fig. 4 shows an arrangement of a first embodiment of the present invention;
Fig. 5 shows an arrangement of a second embodiment of the present invention.
Fig. 6 gives an example of possible pulse sequences of a radiation source relative to a pulsed voltage according to the invention.

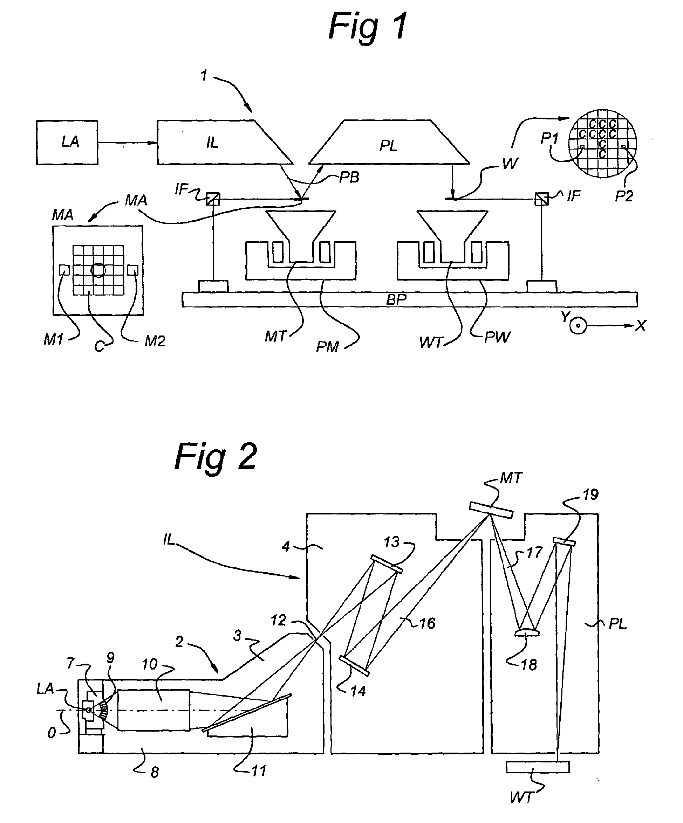

Fig. 1 schematically depicts a lithographic projection apparatus 1 according to a particular embodiment of the invention. The apparatus comprises:
- a radiation system IL for supplying a projection beam PB of radiation (e.g. EUV radiation) with a wavelength of 11-14 nm. In this particular case, the radiation system also comprises a radiation source LA;
- a first object table (mask table) MT provided with a mask holder for holding a mask MA (e.g. a reticle), and connected to first positioning means PM for accurately positioning the mask with respect to item PL;
- a second object table (substrate table) WT provided with a substrate holder for holding a substrate W (e.g. a resist-coated silicon wafer), and connected to second positioning means PW for accurately positioning the substrate with respect to item PL; and
- a projection system ("lens") PL for imaging an irradiated portion of the mask MA onto a target portion C (e.g. comprising one or more dies) of the substrate W.
As here depicted, the apparatus is of a reflective type (i.e. has a reflective mask). However, in general, it may also be of a transmissive type, for example (with a transmissive mask). Alternatively, the apparatus may employ another kind of patterning means, such as a programmable mirror array of a type as referred to above.

The source LA (e.g. a discharge plasma EUV radiation source) produces a beam of radiation. This beam is fed into an illumination system (illuminator) IL, either directly or after having traversed conditioning means, such as a beam expander, for example. The illuminator IL may comprise adjusting means for setting the outer and/or inner radial extent (commonly referred to as σ-outer and σ-inner, respectively) of the intensity distribution in the beam. In addition, it will generally comprise various other components, such as an integrator and a condenser. In this way, the beam PB impinging on the mask MA has a desired uniformity and intensity distribution in its cross-section.

It should be noted with regard to Fig. 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:
1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB; and
2. In scan mode, essentially the same scenario applies, except that a given target portion C is not exposed in a single "flash". Instead, the mask table MT is movable in a given direction (the so-called "scan direction", e.g. the y direction) with a speed ν, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

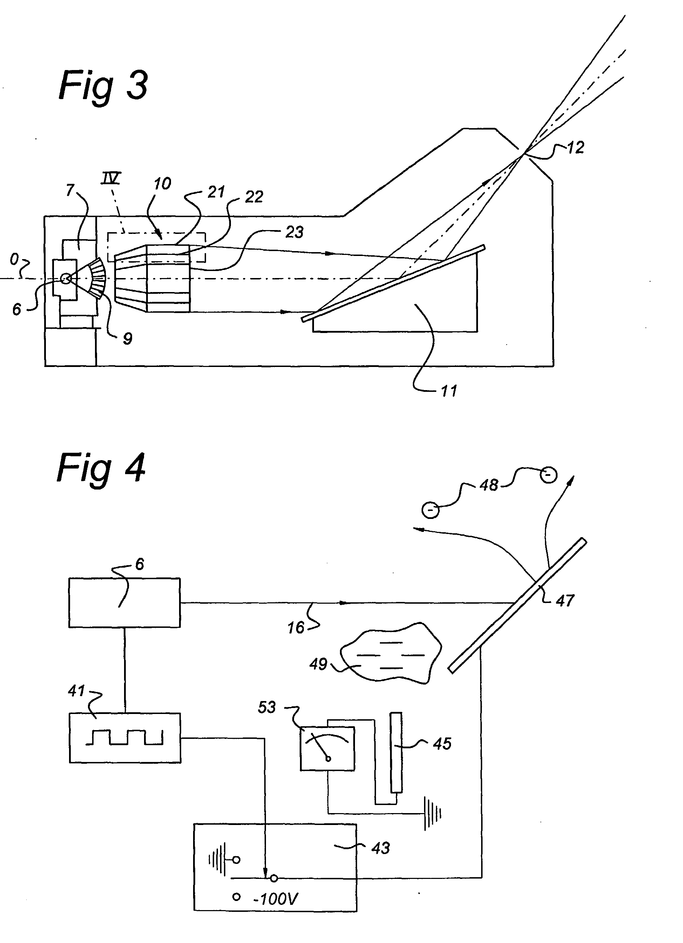

Fig. 2 shows the projection apparatus 1 comprising radiation system IL with a collector source unit or radiation unit 3 and an illumination optics unit 4, and projection optics system PL. Radiation unit 3 is connected to a radiation source unit LA comprising, for example, a discharge plasma source 6 ( Fig. 3 ). EUV radiation source 6 may employ a gas or vapor, such as Xe gas or Li vapor in which a very hot plasma is created to emit radiation in the EUV range of the electromagnetic spectrum. The very hot plasma may be created by causing a partially ionized plasma of an electrical discharge to collapse onto the optical axis O. Partial pressures of 0.1 mbar of Xe gas, Li vapor or any other suitable gas or vapor may be required for efficient generation of the radiation. The radiation emitted by radiation source 6 is passed from the source chamber 7 into collector chamber 8 via a gas barrier structure or "foil trap" 9. The gas barrier structure comprises a channel structure such as, for instance, described in detail in European patent applications EP-A-1 223 468 and EP-A-1 057 079, in the name of the applicant.

The collector chamber 8 comprises a radiation collector 10 which according to the present invention is formed by a grazing incidence collector. Radiation passed by collector 10 is reflected off a grating spectral filter 11 to be focused in a virtual source point 12 at an aperture in the collector chamber 8. From chamber 8, the projection beam 16 is reflected in illumination optics unit 4 via normal incidence reflectors 13, 14 onto a reticle or mask positioned on reticle or mask table MT. A patterned beam 17 is formed which via reflective elements 18, 19 in projection optics system PL is imaged onto wafer stage or substrate table WT. More elements than shown may generally be present in illumination optics unit 4 and projection system PL.

As can be seen in Fig. 3, the grazing incidence collector 10 comprises a number of nested reflector elements 21, 22, 23. A grazing incidence collector of this type is well known in the literature as "Wolter" type and is, for instance, shown in German patent application DE-101 38 284.7.

Fig. 4 shows a first embodiment according to the present invention. The EUV source 6 that can provide a pulsed projection beam of radiation or radiation pulse 16, is connected to a timer circuit 41. The timer circuit 41 receives input from the radiation source 6 and provides an output signal to a voltage source 43 that can supply a voltage, preferably a voltage pulse, to an object 47, for instance an optical component such as a mirror or mask. The voltage maybe shaped as a square wave voltage pulse or a sinusoidal wave voltage pulse. Differently shaped voltage pulses are possible as well. The voltage source 43 is connected to the object 47. When the EUV beam originating from the EUV source 6 impinges on the surface of the object 47 released electrons 48 are being generated. The released electrons 48 may be repelled by a negative voltage. The voltage source 43 can alternately connect the object 47 to a voltage as low as -100 V and ground. In the vicinity of the object 47 an electrode 45 is provided on a voltage, for instance ground, higher than the lower voltage provided by the voltage source 43. The assembly can operate in two ways.

Firstly, the timer circuit 41 can provide the object 47 with a low (negative) voltage pulse during (in phase with) the periods in which the beam of radiation 16 is provided. In this way the generated released electrons 48 are accelerated away from the object 47. However, particles having a positive charge generated during the EUV pulse are attracted and accelerated towards the object 47. Also, because of the presence of a negative voltage on the surface of the object 47 during the EUV radiation, electrons within the object 47 will be attracted to the surface of the object 47, increasing the released electron emission yield only slightly.

Secondly, the timer circuit 41 can provide the object 47 with a low voltage pulse during the periods in which no beam of radiation 16 is provided (out of phase). This leaves the released electron emission yield unaltered. A disadvantage is that a released electron cloud 49 will be present above the surface of the object 47, for a relatively long time, which increases the chance that the released electrons return to the surface of the object 47 causing contamination. It was established that the contamination increases significantly with the released electrons cloud (49) being present for roughly 10 microseconds.

An arbitrary difference in time between application of the low voltage pulse and the beginning of the period during which the beam of radiation 16 is provided is another possibility. This makes it possible to reduce the presence of released electrons and the flux of electrons which are not in phase with the pulse of radiation (for instance electrons resulting from other components in the projection beam).

A lithographic projection apparatus generally comprises several optical components in succession. The radiation pulse 16 traveling along the optical components will arrive at each following optical component at a later time than at the current optical component. Thus, the arrival time of the radiation pulse 16 is different for different optical components. The timer circuit 41 synchronizes the application of the voltage pulse with the arrival of the radiation pulse 16. The width of the voltage pulse has to be such that all the released electrons 48 are collected by the electrode 45. This means that the voltage pulse must have a pulse duration which ends after the end of the (local) EUV beam impinging on the object. The time duration after the end of the EUV beam exposure must be sufficient for all (freed) released electrons to migrate from the object surface to the electrode 45. The amount of released electrons collected is a measure for the dose of radiation and for the amount of contamination on the optical components. The amount of released electrons can be established using measuring means such as for instance a current meter 53.

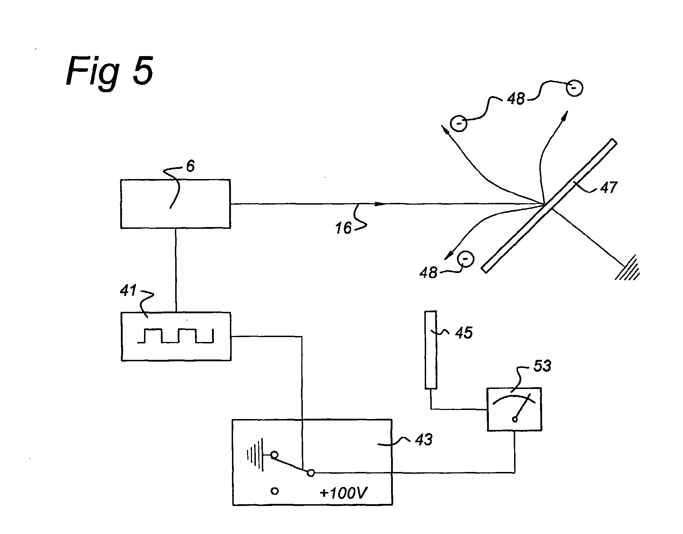

Fig. 5 shows a second embodiment according to the invention. The corresponding reference numerals of Fig. 4 are used. The embodiment of Fig. 5 is comparable with the embodiment of Fig. 4. In contrast to the embodiment of Fig. 4, the voltage source 43 is connected to the electrode 45 and the object 47 is connected to ground instead of to the voltage source 43. The voltage source 43 in Fig. 5 can switch between ground and a relatively high voltage, for instance + 100 V. This voltage attracts or pulls the released electrons 48 to the electrode 45. In the embodiment of Fig. 4 on the contrary, the released electrons 48 are repelled or pushed away from the object 47. The voltage can be applied to the electrode 45 by the voltage source 43 in phase or (partly) out of phase with the pulsed projection beam of radiation 16 from the EUV source 6, as described above.

From calculations it can be shown that for an Argon gas in which the mean free path for electrons and ions is substantially larger than a typical distance in the system (for instance the distance between the respective electrodes) the released electrons take approximately 3.4 ns to cross a 10 mm gap in between the electrodes with a potential difference of 100 V. During this time, the Argon particles however, cross only 10⁻⁵ of the gap length and thus gain an energy of 10⁻⁵ times the potential difference between the electrodes. For a system in which the mean free path is smaller than a typical distance in the system the time it takes the electrons to cross the gap is larger than the 3.4 ns mentioned above. By applying a pulse long enough to have the electrons cross the gap, and short enough not to accelerate the ions significantly, the damage to the object induced by the ion flux significantly decreases with respect to the DC voltage case.

The electrode 45 is typically shaped as a mesh of thin wires, while a typical distance between the electrode 45 and the object 47 is 10 mm. The mesh may be placed in the radiation beam. As long as the wires of the mesh are not too close together, the mesh causes a negligible shadow in the beam. It is also possible to locate the electrode outside the radiation beam so as to have no interference with the radiation beam. A grid type electrode is another possibility.

It is to be noted that apart from measuring the amount of released electrons by using measuring means such as for instance a current meter 53 connected to electrode 45 or an arrangement as disclosed in EP-A-0987601, it is also possible to measure the electrical current on object 47.

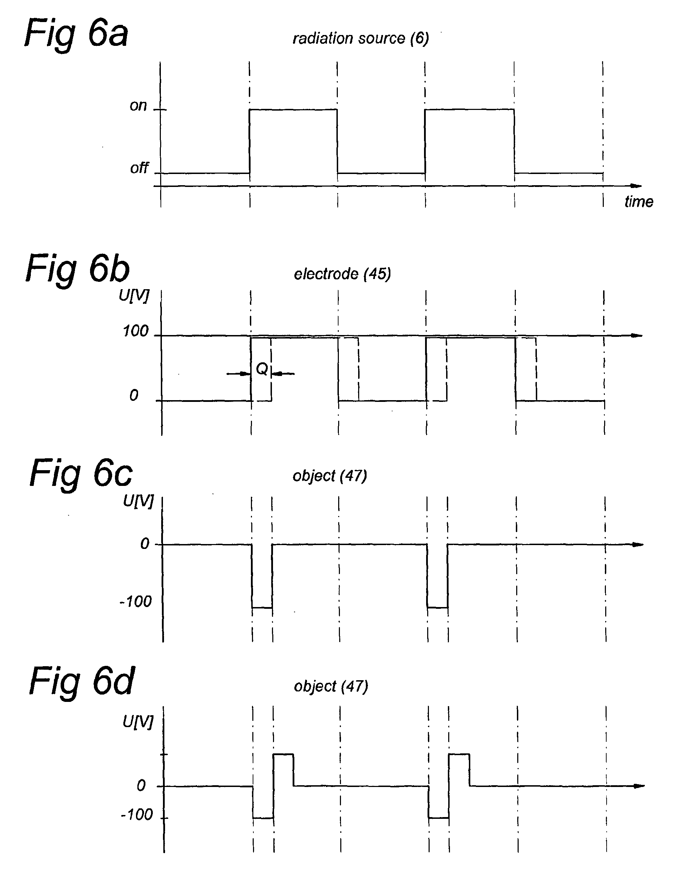

Fig. 6a, 6b, 6c and 6d are meant as an example to illustrate the variation of the radiation from the radiation source 6 and the variation of the potential on the electrode 45 and the object 47, respectively with time. In Fig. 6a a pulse sequence from the radiation source 6 is shown. In Fig. 6b a positive voltage on the electrode 45 is shown. The voltage on the electrode 45 may be provided in phase with the pulse of Fig. 6a, as indicated by the solid line. However, it is also possible to provide the voltage some time after the radiation pulse is provided. This is indicated by the dashed line in Fig. 6b. In this way, there will be a phase difference Q between the radiation pulse and the voltage pulse. The voltage pulse does not have to be present during the entire radiation pulse. In Fig. 6c the variation of a negative voltage pulse on the object 47 to be shielded versus the time is shown. The same remarks with reference to phase difference and presence as explained in connection with Fig. 6b apply. Fig. 6d shows the advantageous variation of the voltage on the object 47 with the time. After application of a negative voltage pulse to remove the present released electrons, the object 47 is charged with a positive voltage pulse. The relatively heavy ions will be acted upon by the force that is generated by the electric field averaged over the time caused by the negative and positive voltage pulses. This time average will be zero or almost zero, so that the ions will not or only slightly be accelerated towards the object 47.

While specific embodiments of the invention have been described above, it will be appreciated that the invention may be practiced otherwise then as described. The description is not intended to limit the invention which is defined by the claims.

## Claims

1. A lithographic projection apparatus (1) comprising:
- a radiation system (3, 4) to form a projection beam of radiation (6'), from radiation emitted by a pulsed radiation source (6),
- a support structure (MT) constructed to hold patterning means (MA), to be irradiated by the projection beam to pattern said projection beam (6'),
- a substrate table (WT) constructed to hold a substrate (W),
- a projection system (5) constructed and arranged to image an irradiated portion of the patterning means (MA) onto a target portion of the substrate (W), and
- shield means for generating a field so as to prevent that released electrons (48), generated as a result of impinging radiation, become incident on an object to be shielded (47),
said shield means comprising:
- an electrode (45) in the vicinity of the object to be shielded (47), and
- a voltage source (43) connected to said object (47) and/or to the electrode (45) for providing a voltage to said object (47) relative to the electrode (45) to generate said field,
**characterized**
**in that** the lithographic apparatus (1) comprises a timer circuit (41) arranged to provide said voltage to the object to be shielded (47) and/or to the electrode (45), such that said voltage is a varying voltage imparting a negative potential to said object (47) relative to the electrode in a timely relation with respect to the radiation pulses.

2. Lithographic projection apparatus (1) according to claim 1, further **characterized in that** the varying voltage imparts the negative potential to the object to be shielded (47) relative to the electrode (45) for a time period sufficient for transporting substantially all the released electrons (48) generated as a result of impinging radiation away from said object (47).

3. Lithographic projection apparatus (1) according to any of the preceding claims, further **characterized in that** the negative potential is provided during a time of between 0,01 microseconds and 10 microseconds, more preferably 0,1 microsecond.

4. Lithographic projection apparatus (1) according to anyone of the preceding claims, further **characterized in that** the negative potential is between 0 V and -1000 V, more preferably -100 V.

5. Lithographic projection apparatus (1) according to anyone of the preceding claims, further **characterized in that** the voltage source (43) is connected to said object (47).

6. Lithographic projection apparatus (1) according to anyone of the preceding claims, further **characterized in that** the voltage source (43) is connected to the electrode (45) in the vicinity of the object to be shielded (47).

7. Lithographic projection apparatus (1) according to anyone of the preceding claims, further **characterized in that** the negative potential is applied in phase with the pulses of radiation.

8. Lithographic projection apparatus (1) according to anyone of the claims 1-6, further **characterized in that** the phase difference between the application of the negative potential and the pulses of radiation is arbitrary.

9. Lithographic projection apparatus (1) according to anyone of the preceding claims, further **characterized in that** the negative potential is succeeded by an associated positive potential.

10. Lithographic projection apparatus (1) according to claim 9, further **characterized in that** the positive voltage is between 0 V and +1000 V more preferably +100 V.

11. Lithographic projection apparatus (1) according to anyone of the preceding claims, further **characterized in that** the varying voltage has the form of square wave.

12. Lithographic projection apparatus (1) according to anyone of the claims 1 to 11, further **characterized in that** the varying voltage has the form of a sinusoidal wave.

13. Lithographic projection apparatus (1) according to anyone of the preceding claims, further **characterized in that** the lithographic projection apparatus (1) comprises measuring means (53) for measuring a current generated by the released electrons (48) in the electrode (45).

14. Method of manufacturing an integrated structure by a lithographic process comprising the steps of:
- providing a radiation system (3, 4) to form a projection beam of radiation (6'), from radiation emitted by a radiation source (6), wherein said radiation is pulsed,
- providing a support structure (MT) constructed to hold patterning means (MA), to be irradiated by the projection beam (6') to pattern said projection beam (6'),
- providing a substrate table (WT) constructed to hold a substrate (W),
- providing a projection system (5) constructed and arranged to image an irradiated portion of the patterning means (MA) onto a target portion of the substrate (W), and
- generating a field so as to prevent that released electrons (48), generated as a result of impinging radiation, become incident on an object to be shielded (47); **characterized by**
- providing a varying voltage to generate said field to the object to be shielded (47) and/or to an electrode (45) provided in the vicinity of said object (47), the varying voltage imparting a negative potential to the object to be shielded (47) relative to the electrode (45) in a timely relation with respect to the radiation pulses.

15. Method according to claim 15, further **characterized in that** the amount of released electrons (48) incident on the electrode (45) is measured.

## Patentansprüche

1. Lithographische Projektionsvorrichtung (1), die folgendes aufweist:
- ein Strahlungssystem (3, 4), um einen Projektionsstrahl (6') aus einer Strahlung zu bilden, die von einer gepulsten Strahlungsquelle (6) emittiert wird,
- eine Abstützkonstruktion (MT), die zum Halten einer Strukturierungseinrichtung (MA) ausgebildet ist, um für die Strukturierung des Projektionsstrahls (6') mit dem Projektionsstrahl bestrahlt zu werden,
- einen Substrattisch (WT), der zum Halten eines Substrats (W) ausgebildet ist,
- ein Projektionssystem (5), das zum Abbilden eines bestrahlten Bereichs der Strukturierungseinrichtung (MA) auf einen Zielbereich des Substrats (W) ausgebildet und angeordnet ist, und
- eine Abschirmeinrichtung zum Erzeugen eines Felds, um zu verhindern, daß freigesetzte Elektronen (48), die als Resultat von auftreffender Strahlung erzeugt werden, auf ein abzuschirmendes Objekt (47) auftreffen,
wobei die Abschirmeinrichtung folgendes aufweist:
- eine Elektrode (45) in der Nähe des abzuschirmenden Objekts (47) und
- eine Spannungsquelle (43), die mit dem Objekt (47) und/oder mit der Elektrode (45) verbunden ist, um eine Spannung gegenüber der Elektrode (45) an das Objekt (47) anzulegen, um das Feld zu erzeugen,
**dadurch gekennzeichnet,**
**daß** die lithographische Projektionsvorrichtung (1) eine Zeitgeberschaltung (41) aufweist, die zum Anlegen der Spannung an das abzuschirmende Objekt (47) und/oder die Elektrode (45) in einer derartigen Weise ausgebildet ist, daß es sich bei Spannung um eine variierende Spannung handelt, die das Objekt (47) gegenüber der Elektrode mit einem negativen Potential in zeitlicher Relation zu den Strahlungsimpulsen beaufschlagt.

2. Lithographische Projektionsvorrichtung (1) nach Anspruch 1,
weiterhin **dadurch gekennzeichnet,**
**daß** die variierende Spannung das abzuschirmende Objekt (47) gegenüber der Elektrode (45) mit dem negativen Potential für eine Zeitdauer beaufschlagt, die ausreichend ist, um im wesentlichen alle freigesetzten Elektronen (48), die als Resultat von auftreffender Strahlung erzeugt werden, von dem Objekt (47) wegzutransportieren.

3. Lithographische Projektionsvorrichtung (1)
nach einem der vorhergehenden Ansprüche,
weiterhin **dadurch gekennzeichnet,**
**daß** das negative Potential während einer Zeitdauer von 0,01 ms bis 10 ms, in weiter bevorzugter Weise für 0,1 ms, angelegt wird.

4. Lithographische Projektionsvorrichtung (1)
nach einem der vorhergehenden Ansprüche,
weiterhin **dadurch gekennzeichnet,**
**daß** das negative Potential 0 V bis -1000 V, in weiter bevorzugter Weise -100 V, beträgt.

5. Lithographische Projektionsvorrichtung (1)
nach einem der vorhergehenden Ansprüche,
weiterhin **dadurch gekennzeichnet,**
**daß** die Spannungsquelle (43) mit dem Objekt (47) verbunden ist.

6. Lithographische Projektionsvorrichtung (1)
nach einem der vorhergehenden Ansprüche,
weiterhin **dadurch gekennzeichnet,**
**daß** die Spannungsquelle (43) in der Nähe des abzuschirmenden Objekts (47) mit der Elektrode (45) verbunden ist.

7. Lithographische Projektionsvorrichtung (1)
nach einem der vorhergehenden Ansprüche,
weiterhin **dadurch gekennzeichnet,**
**daß** das negative Potential in Phase mit den Strahlungsimpulsen angelegt wird.

8. Lithographische Projektionsvorrichtung (1)
nach einem der Ansprüche 1 bis 6,
weiterhin **dadurch gekennzeichnet,**
**daß** die Phasendifferenz zwischen dem Anlegen des negativen Potentials und den Strahlungsimpulsen beliebig ist.

9. Lithographische Projektionsvorrichtung (1)
nach einem der vorhergehenden Ansprüche,
weiterhin **dadurch gekennzeichnet,**
**daß** auf das negative Potential ein zugeordnetes positives Potential folgt.

10. Lithographische Projektionsvorrichtung (1) nach Anspruch 9,
weiterhin **dadurch gekennzeichnet,**
**daß** die positive Spannung von 0 V bis +1000 V und in weiter bevorzugter Weise +100 V beträgt.

11. Lithographische Projektionsvorrichtung (1)
nach einem der vorhergehenden Ansprüche,
weiterhin **dadurch gekennzeichnet,**
**daß** die variierende Spannung die Form einer Rechteckwelle aufweist.

12. Lithographische Projektionsvorrichtung (1)
nach einem der Ansprüche 1 bis 11,
weiterhin **dadurch gekennzeichnet,**
**daß** die variierende Spannung die Form einer Sinuswelle aufweist.

13. Lithographische Projektionsvorrichtung (1)
nach einem der vorhergehenden Ansprüche,
weiterhin **dadurch gekennzeichnet,**
**daß** die lithographische Projektionseinrichtung (1) ferner eine Meßeinrichtung (53) zum Messen eines von den freigesetzten Elektronen (48) in der Elektrode (45) erzeugten Stroms aufweist.

14. Verfahren zum Herstellen einer integrierten Struktur mit einem lithographischen Prozeß, wobei das Verfahren folgende Schritte aufweist:
- Bereitstellen eines Strahlungssystems (3, 4), um einen Projektionsstrahl (6') aus einer Strahlung zu bilden, die von einer Strahlungsquelle (6) emittiert wird, wobei die Strahlung gepulst wird,
- Bereitstellen einer Abstützkonstruktion (MT), die zum Halten einer Strukturierungseinrichtung (MA) ausgebildet ist, um für die Strukturierung des Projektionsstrahls (6') mit dem Projektionsstrahl (6') bestrahlt zu werden,
- Bereitstellen eines Substrattisches (WT), der zum Halten eines Substrats (W) ausgebildet ist,
- Bereitstellen eines Projektionssystems (5), das zum Abbilden eines bestrahlten Bereichs der Strukturierungseinrichtung (MA) auf einen Zielbereich des Substrats (W) ausgebildet und angeordnet ist, und
- Erzeugen eines Felds, um zu verhindern, daß freigesetzte Elektronen (48), die als Resultat von auftreffender Strahlung erzeugt werden, auf ein abzuschirmendes Objekt (47) auftreffen,
**gekennzeichnet durch**
- Anlegen einer variierenden Spannung zum Erzeugen des Feldes an das abzuschirmende Objekt (47) und/oder eine in der Nähe des Objekts (47) vorgesehenen Elektrode (45), wobei die variierende Spannung das abzuschirmende Objekt (47) gegenüber der Elektrode (45) mit einem negativen Potential in zeitlicher Relation zu den Strahlungsimpulsen beaufschlagt.

15. Verfahren nach Anspruch 14,
weiterhin **dadurch gekennzeichnet,**
**daß** die Menge der freigesetzten Elektronen (48), die auf die Elektrode (45) auftreffen, gemessen wird.

## Revendications

1. Dispositif de projection lithographique (1) comprenant :
- un système de rayonnement (3, 4) pour former un faisceau de rayonnement de projection (6'), à partir d'un rayonnement émis par une source de rayonnement pulsé (6),
- une structure de support (MT) construite de façon à supporter des moyens de réalisation de motif (MA), destinés à être irradiés par le faisceau de projection de façon à mettre sous un certain motif ledit faisceau de projection (6'),
- une table de substrat (WT) construite pour supporter un substrat (W),
- un système de projection (5) construit et agencé de façon à réaliser une image d'une partie irradiée des moyens de réalisation de motif (MA) sur une partie cible du substrat (W), et
- des moyens de blindage pour générer un champ de façon à empêcher que des électrons libérés (48), générés à la suite d'un impact de rayonnement, ne deviennent incidents sur un objet devant être blindé (47),
lesdits moyens de blindage comprenant :
- une électrode (45) au voisinage de l'objet devant être blindé (47), et
- une source de tension (43) connectée audit objet (47) et/ou à l'électrode (45) pour délivrer une tension audit objet (47) par rapport à l'électrode (45) de façon à générer ledit champ,
**caractérisé :**
**en ce que** le dispositif lithographique (1) comprend un circuit de minuteur (41) agencé de façon à délivrer ladite tension à l'objet devant être blindé (47) et/ou à l'électrode (45), de telle sorte que ladite tension soit une tension variable communiquant un potentiel négatif audit objet (47) par rapport à l'électrode selon une relation minutée par rapport aux impulsions de rayonnement.

2. Dispositif de projection lithographique (1) selon la revendication 1, **caractérisé de plus en ce que** la tension variable communique le potentiel négatif à l'objet devant être blindé (47) par rapport à l'électrode (45) pendant une période de temps suffisante pour transporter sensiblement tous les électrons libérés (48) générés à la suite d'un impact de rayonnement loin dudit objet (47).

3. Dispositif de projection lithographique (1) selon l'une quelconque des revendications précédentes, **caractérisé de plus en ce que** le potentiel négatif est délivré pendant un temps compris entre 0,01 microseconde et 10 microsecondes, et, de façon plus préférable, pendant 0,1 microseconde.

4. Dispositif de projection lithographique (1) selon l'une quelconque des revendications précédentes, **caractérisé de plus en ce que** le potentiel négatif est compris entre 0 V et -1000 V, et est, de façon plus préférable, de -100 V.

5. Dispositif de projection lithographique (1) selon l'une quelconque des revendications précédentes, **caractérisé de plus en ce que** la source de tension (43) est connectée audit objet (47).

6. Dispositif de projection lithographique (1) selon l'une quelconque des revendications précédentes, **caractérisé de plus en ce que** la source de tension (43) est connectée à l'électrode (45) au voisinage de l'objet devant être blindé (47).

7. Dispositif de projection lithographique (1) selon l'une quelconque des revendications précédentes, **caractérisé de plus en ce que** le potentiel négatif est appliqué en phase avec les impulsions de rayonnement.

8. Dispositif de projection lithographique (1) selon l'une quelconque des revendications 1 à 6, **caractérisé de plus en ce que** la différence de phase entre l'application du potentiel négatif et les impulsions de rayonnement est arbitraire.

9. Dispositif de projection lithographique (1) selon l'une quelconque des revendications précédentes, **caractérisé de plus en ce que** le potentiel négatif est suivi par un potentiel positif associé.

10. Dispositif de projection lithographique (1) selon la revendication 9, **caractérisé de plus en ce que** la tension positive est comprise entre 0 V et +1000 V, et est, de façon plus préférable, de +100 V.

11. Dispositif de projection lithographique (1) selon l'une quelconque des revendications précédentes, **caractérisé de plus en ce que** la tension variable a la forme d'une onde carrée.

12. Dispositif de projection lithographique (1) selon l'une quelconque des revendications 1 à 11, **caractérisé de plus en ce que** la tension variable a la forme d'une onde sinusoïdale.

13. Dispositif de projection lithographique (1) selon l'une quelconque des revendications précédentes, **caractérisé de plus en ce que** le dispositif de projection lithographique (1) comprend des moyens de mesure (53) pour mesurer un courant généré par les électrons libérés (48) dans l'électrode (45).

14. Procédé de fabrication d'une structure intégrée par un processus lithographique, comprenant les étapes consistant à :
- disposer un système de rayonnement (3, 4) pour former un faisceau de rayonnement de projection (6'), à partir d'un rayonnement émis par une source de rayonnement (6), ledit rayonnement étant pulsé,
- disposer une structure de support (MT) construite de façon à supporter des moyens de réalisation de motif (MA), destinés à être irradiés par le faisceau de projection (6') de façon à mettre sous un certain motif ledit faisceau de projection (6'),
- disposer une table de substrat (WT) construite pour supporter un substrat (W),
- disposer un système de projection (5) construit et agencé de façon à réaliser une image d'une partie irradiée des moyens de réalisation de motif (MA) sur une partie cible du substrat (W), et
- générer un champ de façon à empêcher que des électrons libérés (48), générés à la suite d'un impact de rayonnement, ne deviennent incidents sur un objet devant être blindé (47) ;
**caractérisé par** :
- la délivrance d'une tension variable pour générer ledit champ vers l'objet devant être blindé (47) et/ou vers une électrode (45) disposée au voisinage dudit objet (47), la tension variable communiquant un potentiel négatif à l'objet devant être blindé (47) par rapport à l'électrode (45) selon une relation minutée par rapport aux impulsions de rayonnement.

15. Procédé selon la revendication 15, **caractérisé de plus en ce que** la quantité d'électrons libérés (48) incidents sur l'électrode (45) est mesurée.
